# EUROPEAN PATENT APPLICATION

(11) **EP 0 851 473 A2**
(43) Date of publication of application: **01.07.1998**
(21) Application number: 97310536.4
(22) Date of filing: 23.12.1997
(51) Int. Cl.: H01L 21/3205

(54) **Method of making a layer with high dielectric K, gate and capacitor insulator layer and device**

(30) Priority: 23.12.1996 US 33840 P
(71) Applicant: LUCENT TECHNOLOGIES INC., Murray Hill, New Jersey 07974-0636 (US)
(72) Inventor: Kizilyalli, Isik C., Orlando, Florida 32819 (US); Kumar Roy, Pradip, Orlando, Florida 32819 (US); Ma, Yi, Orlando, Florida 32837 (US)
(74) Representative: Buckley, Christopher Simon Thirsk

(57) **Abstract**

A method of making a gate or capacitor insulator structure using a first grown oxide layer (3), depositing a high-k dielectric material (4) on the grown oxide layer, and then depositing an oxide layer (5). The deposited oxide layer is then desirably densified in an oxidizing atmosphere. A conductive layer (6), such as a gate or capacitor plate, may be then formed on the deposited oxide layer. The resulting structure has a first grown oxide layer (3), a high-k dielectric material (4) on the grown oxide layer, and a deposited oxide layer (5) on the high-k dielectric oxide layer. Conductive layer (6) on the deposited oxide layer may be used as a gate or a capacitor plate.

## Description

### Background of the Invention

### Field of the Invention

This invention relates to integrated circuits in general and, more particularly, to gate/capacitor dielectrics having a high dielectric constant (high K).

### Description of the Prior Art

As feature sizes on integrated circuits get smaller, the amount of capacitance for a given circuit element decreases, such as with a memory storage capacitor, and operating voltages are decreased.

For transistors to operate reliably at lower voltages,the threshold voltage of the transistor is correspondingly lowered. One approach to lower the threshold voltage is to thin the insulating layer (usually a single layer of silicon dioxide) separating the transistor gate from the transistor channel. But at very thin insulating thicknesses (e.g., an oxide layer thickness of less than 3.5 nm), the oxide layer suffers from pinholes and leakage may be too large. Further, if the oxide layer is less than about 2.5 nm, tunneling of electrons from the transistor channel may occur, degrading transistor performance. Alternatively, the gate may be effectively "moved" closer to the channel by incorporating a high dielectric constant (k) material as the gate insulator between the gate and the transistor channel. However, this approach with high-k materials (such as ferroelectric dielectrics) has not been entirely satisfactory because of defects within the dielectric and also at the silicon/dielectric interface, due for example by lattice mismatch, causing excessive gate to substrate leakage.

The reduced feature size and lower operating voltage is of special concern with dynamic memories where capacitors are used to store information. As more memory cells are added to a given memory array and feature sizes are decreased so that the extra cells can be added within a reasonable chip size, the size of the storage capacitors are correspondingly decreased. With lower capacitance of the storage capacitors and reduced voltage on the capacitors, the memory may become more error prone. To compensate for the reduction in capacitor size and still maintain capacitance, two approaches can be used singly or in combination: dielectric thinning and increasing the dielectric constant. But the same problems with both approaches discussed above apply here as well.

From a practical point of view, the use of high-k materials may be the most desirable choice to solve the above problems at feature sizes of 0.35 µm and below if the leakage/defects problems can be satisfactorily solved.

Therefore, there exists a need for incorporating high dielectric materials into integrated circuit designs with reduced defect and leakage problems of the heretofore approaches of device fabrication incorporating high dielectric constant materials.

### Summary of the Invention

This and other aspects of the invention may be obtained generally with a method of making an integrated circuit according to claim 1. Further, the above aspects may be obtained generally with an integrated circuit having a structure as recited in claim 6.

### Brief Description of the Drawing

The foregoing features of this invention, as well as the invention itself, may be more fully understood from the following detailed description of the drawings, in which:
FIG. 1 is a cross section of a partially formed exemplary transistor having a gate oxide fabricated according to one embodiment of the invention; and
FIG. 2 is a cross section of a partially fabricated exemplary polysilicon-to-polysilicon capacitor with a diclectric layer fabricated according to another embodiment of the invention.

### Detailed Description

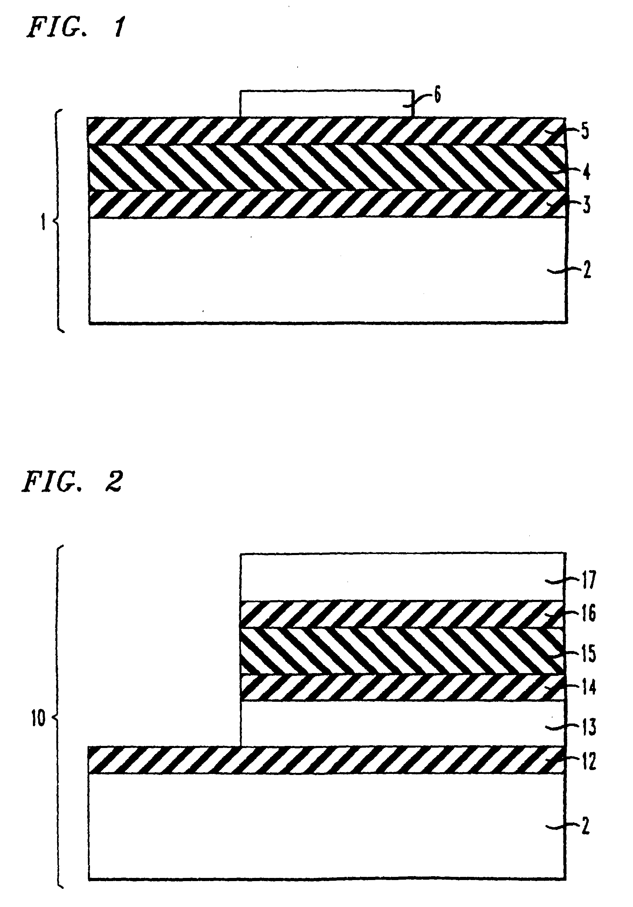

Generally, the invention may understood by referring to FIG. 1. As discussed below in more detail and in accordance with one embodiment of the invention, a wafer 1 having an oxidizable layer 2, here a silicon substrate but may be any oxidizable layer such as a polysilicon layer, has grown thereon an insulating layer 3, the layer 3 being preferably an oxide of the substrate 2. On the layer 3 is deposited a layer of a high dielectric constant material 4 (referred to herein as a high-k dielectric material), to be described below. Over layer 4 is deposited an oxide layer 5. Preferably the deposited oxide layer 5 is densified.

In more detail, the wafer 1 includes an exemplary silicon substrate 2 which has grown thereon an oxide layer 3, here a silicon dioxide layer with the silicon coming substantially the substrate 2. The layer 3 is preferably grown in a conventional dry oxidizing atmosphere at 0.25 to 10 torr and 650° to 900°C to form 1 to 2 nm thick oxide, the thicknesses not being critical but of sufficient thickness to avoid substantial pinhole formation and a good substrate/oxide interface. While the oxide is preferably grown in a dry atmosphere, it may be grown in a wet (steam) atmosphere.

The layer 3 is believed to help reduce strain between the later deposited high-k dielectric layer 4 and the underlying silicon substrate 2 and provides a good interface with the silicon to reduce undesired surface states in the silicon. Without the layer 3, it is believed that a lattice mismatch between the substrate 2 and the later deposited layer 4 creates defects at the interface between the layers, decreasing the overall quality of the dielectric.

Over the grown dielectric layer 3 is deposited a layer or layers 4 of a high-k dielectric material, which by way of example may be a ferroelectric dielectric material, this material having a dielectric constant greater than that of silicon dioxide. This material may be of group of materials including Ta₂ O₅, TiO ₂, SrO ₃, and perovskite materials of the form MTiO₃, where M may be Sr, Ba, La, Ph_{,} Baₓ Sr₁₋ₓ, and Phₓ La₁₋ₓ. It is understood that combinations of these layers may be used or interposed insulating layers, such as silicon dioxide, may be added. Exemplary thickness of the layer 4 is from 2 to 20 nm and done in a plasma enhanced, ion-beam assisted, or ozone low pressure chemical vapor deposition (LPCVD) or metalorganic chemical vapor deposition (MOCVD) processes. Examples of these processes are as disclosed in "Preparation of (Ba, Sr)TiO3 Thin Films by Chemical Vapor Deposition using Liquid Sources,"by T. Kawahara et al., Japanese Journal of Applied Physics, V33, no. 10, 1994, pp. 5897 - 5902, and "Preparation of PbTiO3 Thin Films by Plasma Enhanced Metalorganic Chemical Vapor Deposition," by E. Fuji et al., Applied Physics Letters, Vol. 65, no. 3, 1994, pp. 365 - 367, included herein by reference.

After the formation of layer 4, a layer 5 of silicon dioxide is deposited. This layer is preferably 1 to 3 nm thick and preferably formed in a LPCVD reactor (not shown), preferably the same as that used to deposit layer 4. Typical source gasses for the silicon include tetraethylorthosilicate gases (TEOS) or silane.

The layer 5 may be desirably densified by exposing the wafer 1 to a conventional densification anneal process in an oxidizing ambient atmosphere. An example of such a process step is in an LPCVD reactor operating at a pressure of 250 millitorr to 10 torr with temperatures between 650° and 900°C for approximately 5 - 20 minutes. The oxidizing atmosphere may include N₂O to add nitrogen to the layer 5.

The densification step helps improves the overall quality of the layer 5, remove traps (defects) in the layers 3 - 5, and reduces the overall leakage through the layers 3 - 5.

An exemplary conductive layer 6, such as polysilicon, is shown on layer 5. This layer 6 may be a gate or one plate of a capacitor (the other plate being the substrate 2 or an upper layer not shown), the combination of layers 3 - 5 being referred to herein as a gate or capacitor insulating layer. It is understood that the densification step described above may be done after the formation of layer 6 with the attendant oxidation of the layer 6 if unprotected.

An alternative embodiment is shown in FIG. 2 for an exemplary polysilicon-to-polysilicon capacitor structure. Here a wafer 10 has thereon an insulating layer 12 to separate an exemplary oxidizable and conductive layer 13, such as amorphous or polysilicon (the amorphous silicon being rendered conductive at a later step). Layers 14 - 16 correspond to layers 3 - 5 in FIG. 1 as described above. Layer 17, also preferably a conductive layer, along with layer 13 forms the plates of a capacitor while layers 14-16 form the capacitor insulating layer.

While silicon is described as the material type for the substrate and other layers, it is understood that other materials may be used, such as GaAs, InP, etc.

## Claims

1. A method of making an integrated circuit having an oxidizable layer (2) with a surface, including the step of:
growing an oxide layer (3) on the oxidizable surface; and characterized by the steps of
depositing a high-k dielectric layer (4) on the grown oxide layer; and
depositing an oxide layer (5) on the high-k dielectric layer.

2. The method as recited in claim 1, further comprising the step of:
densifying the deposited oxide in an oxidizing atmosphere.

3. The method as recited in claim 2, wherein the high-k dielectric layer is selected from the group of Ta₂O₅, TiO₂, and perovskite materials.

4. The method as recited in claim 2, wherein the perovskite material is of the form MTiO₃, where M is selected from the group of Sr, Ba, La, Ti, Pb, BaₓSr₁₋ₓ and Pb ₓ La₁₋ₓ.

5. The method as recited in claim 2, wherein the oxide layers are oxides of silicon, and the oxidizable layer is a silicon substrate.

6. The method as recited in claim 5, further comprising the step of depositing a conductive layer on the deposited oxide layer.

7. An integrated circuit having an oxidizable layer (2) with a surface having a grown oxide layer (3) on the oxidizable surface; characterized by
a high-k dielectric layer (4) on the grown oxide layer; and
a deposited oxide layer (5) on the high-k dielectric layer.

8. The integrated circuit as recited in claim 7, wherein the deposited oxide layer is a densified deposited oxide layer.

9. The integrated circuit as recited in claim 8, wherein the high-k dielectric layer is selected from the group of Ta ₂O₅, TiO ₂, and perovskite materials.

10. The integrated circuit as recited in claim 8, wherein the perovskite material is of the form MTiO₃, where M is selected from the group of Sr, Ba, La, Ti, Pb, Baₓ Sr ₁₋ₓ and PbₓLa ₁₋ₓ.

11. The integrated circuit as recited in claim 8, wherein the oxide layers are oxides of silicon, and the oxidizable layer is a silicon substrate.
